# EUROPÄISCHE PATENTSCHRIFT

(11) **EP 3 399 632 B1**
(45) Veröffentlichungstag und Bekanntmachung des Hinweises auf die Patenterteilung: **04.05.2022**
(21) Anmeldenummer: 18180446.9
(22) Anmeldetag: 25.07.2005
(51) Int. Cl.: H02M 3/157, H05B 41/28, H05B 41/288, H03K 17/16, H05B 41/282

(54) **ANSTEUERUNG VON HALBLEITER-LEISTUNGSSCHALTERN**
CONTROL OF SEMICONDUCTOR POWER SWITCHES
COMMANDE DE COMMUTATEURS DE PUISSANCE À SEMI-CONDUCTEUR

(30) Priorität: 30.07.2004 DE 102004036958
(43) Veröffentlichungstag der Anmeldung: 07.11.2018
(62) Teilanmeldung aus: 10173357.4
(73) Patentinhaber: Tridonic GmbH & Co. KG, 6851 Dornbirn (AT)
(72) Erfinder: Zudrell-Koch, Stefan, 6845 Hohenems (AT); Knoedgen, Horst, 80997 München (DE)
(74) Vertreter: Rupp, Christian

(56) Entgegenhaltungen:
- DE-A1- 10 120 789
- DE-A1- 19 940 579
- US-A1- 2002 093 363

## Beschreibung

Die vorliegende Erfindung bezieht sich allgemein auf das Gebiet der Ansteuerung von Leistungsschaltern, wie sie beispielsweise in einer PFC (Power Factor Control)-Schaltung Verwendung finden können.

Die Druckschrift US 2002/0093363 A1 offenbart eine programmierbare und konfigurierbare Ausgangspufferschaltung mit einem Eingangs- und einem Ausgangsterminal. Die Ausgangspufferschaltung umfasst eine Ausgangspufferstufe ohne Verzögerungseinheit und eine oder mehrere Ausgangspufferstufen mit einer Verzögerungseinheit, sowie eine programmierbare Speichereinheit zur Steuerung einer Ausgangskonfiguration.

Die Druckschrift DE 199 40 579 A1 offenbart eine Vorrichtung zum Betreiben einer elektrischen Last. Die Vorrichtung umfasst ein Schaltelement, welches in einem Stromzufuhrpfad von einer Gleichstrom-Energiequelle zu der elektrischen Last angeordnet ist.

Die Druckschrift DE 101 20 789 A1 betrifft ein Verfahren bzw. eine Schaltungsanordnung zum Aktivieren eines mit verringerter Leistung betriebenen oder abgeschalteten elektrischen Schaltkreises insbesondere aus einem Standby-Zustand.

Aus dem Stand der Technik ist es bereits bekannt, daß ein bestimmter zeitlicher Verlauf, insbesondere im Bereich der Flanken, des Schaltverhaltens eines Leistungsschalters vorteilhaft hinsichtlich einer Verringerung der durch den Schaltvorgang erzeugten elektromagnetischen Störungen (EMI, Electromagnetic Interference) ist.

Die vorliegende Erfindung geht von dieser Erkenntnis aus und hat sich zur Aufgabe gemacht, eine Technik bereitzustellen, mittels der in flexibler Weise auch unterschiedlichen Leistungsschaltern ein gewünschtes Schaltungsverhalten auferlegt werden kann.

Diese Aufgabe wird erfindungsgemäß durch die Merkmale der unabhängigen Ansprüche gelöst. Spezielle Ausführungsformen werden in den abhängigen Ansprüchen definiert.

Gemäß einem ersten Aspekt der Erfindung ist ein Verfahren zur geregelten Ansteuerung eines Leistungsschalters zur elektrischen Versorgung von Geräten vorgesehen. Dabei wird zuerst ein Sollverhalten des Stroms und/oder der Spannung durch den bzw. an den Leistungsschalter zumindest für einen zeitlichen Abschnitt eines Schaltvorgangs vorgegeben.

Das tatsächliche Verhalten (Istverhalten) dieses Parameters wird gemessen und zur Bildung einer geschlossenen Regelschleife zurückgeführt. Schließlich wird das gemessene Istverhalten mit dem Sollverhalten verglichen und die Ansteuerung des Leistungsschalters derart bewirkt, daß das Istverhalten im wesentlichen dem Sollverhalten folgt.

Das Sollverhalten kann insbesondere den Flankenverlauf des Schaltvorgangs, beispielsweise anhand wenigstens zweier Stützpunkte vorgeben.

Werte, die das Sollverhalten wiedergeben, können beispielsweise als diskrete Werte in einem Speicher abgelegt sein. Alternativ oder zusätzlich kann das Sollverhalten auch mittels einer analogen Schaltung, beispielsweise mittels eines Rechteck-Oszillators mit begrenzter Flankensteilheit, vorgegeben werden.

Die vorliegende Erfindung bezieht sich gemäß einem weiteren Aspekt auch auf ein Verfahren zur Kalibrierung des Schaltverhaltens eines Leistungsschalters. Dabei wird der Strom und/oder die Spannung durch den bzw. an dem Leistungsschalter zumindest für einen zeitlichen Abschnitt eines Schaltvorgangs gemessen. Daraufhin wird die Ansteuerung des Leistungsschalters dahingehend abgeglichen, daß zur Erzielung einer geringen elektromagnetischen Störung während des Schaltverhaltens das tatsächliche Schaltverhalten im wesentlichen einem vorgegebenen Sollverhalten entspricht, wobei das Sollverhalten hinsichtlich der elektromagnetischen Interferenz (EMI) optimiert ist.

Ein derartiges Kalibrierverfahren kann beispielsweise für einen Leistungsschalter in einer PFC-Schaltung verwendet werden.

Die Erfindung bezieht sich auch auf ein Computersoftware-Programmprodukt, das ein derartiges Verfahren implementiert, wenn es auf einer Recheneinrichtung läuft, beispielsweise in einem ASIC programmiert ist.

Schließlich bezieht sich die vorliegende Erfindung auch auf eine Leistungsschalter-Regelschaltung. Diese Regelschaltung weist Mittel zur Vorgabe eines Sollverhaltens des Stroms und/der Spannung durch einen bzw. an einem Leistungsschalter zumindest für einen zeitlichen Abschnitt eines Schaltvorgangs auf. Weiterhin sind Mittel zur Messung des Istverhaltens sowie zur Rückführung des Meßergebnisses vorgesehen. Schließlich ist eine Regeleinrichtung vorgesehen, die die Ansteuerung des Leistungsschalters derart ausführt, daß das Istverhalten im wesentlichen dem Sollverhalten entspricht.

Diese Regeleinrichtung kann beispielsweise ein ASIC und/oder eine diskrete Schaltung sein.

Schließlich bezieht sich die vorliegende Erfindung auch auf ein System zur Kalibrierung des Schaltverhaltens eines Leistungsschalters, auf ein Betriebsgerät für Leuchtelemente, auf ein elektronisches Vorschaltgerät (EVG) für Gasentladungslampen sowie auf eine PFC-Schaltung, die jeweils eine derartige Regelschaltung aufweisen.

Weitere Eigenschaften, Vorteile und Merkmale der vorliegenden Erfindung sollen nunmehr bezugnehmend auf die Figuren der beigefügten Zeichnungen näher erläutert werden.
Fig. 1 zeigt dabei eine schematische Übersicht über eine erfindungsgemäße analoge Regelschaltung,
Fig. 2 zeigt eine schematische Übersicht über eine erfindungsgemäße digitale Regelschaltung,
Fig. 3 zeigt eine erfindungsgemäße Kalibrierung einer Ansteuerschaltung, und
Fig. 4 zeigt die Anwendung einer erfindungsgemäßen Regelschaltung im Rahmen einer PFC (Power Factor Correction)-Schaltung.

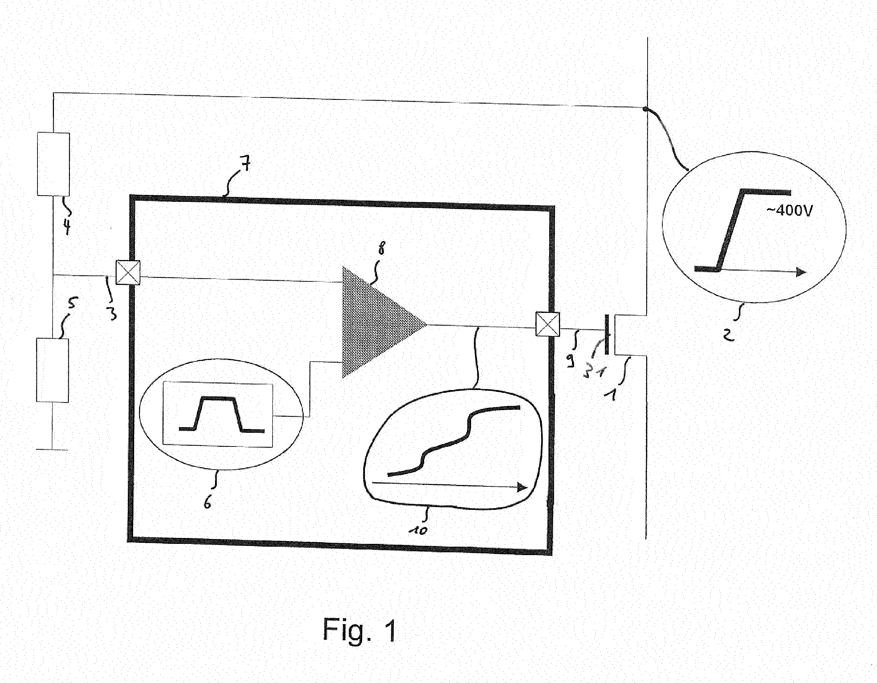

In Fig. 1 ist ein Leistungsschalter als FET-Transistor 1 ausgebildet. Dem Steuereingang (hier: Gate) 31 dieses Leistungsschalters 1 wird ein Ansteuersignal 9 von einer Regeleinrichtung zugeführt, die im vorliegenden Ausführungsbeispiel eine integrierte Schaltung (ASIC) 7 sein kann, beispielsweise aber auch als diskrete oder hybride Schaltung aufgebaut sein kann.

Mittels eines Spannungsteilers aufweisend Widerstände 4, 5 wird ein Parameter des Schaltverhaltens des Leistungsschalters 1 zumindest während eines Teils der Zeitdauer von Schaltvorgängen, insbesondere während der Flanken, erfaßt. Dieser Parameter kann beispielsweise der Strom *I* durch den Leistungsschalter 1 und/oder die Spannung U an dem Leistungsschalter 1 sein.

Wie bereits erwähnt kann die Messung/Regelung auf bestimmte zeitliche Abschnitte wie bspw. die dynamischen Bereiche (Flanken) begrenzt sein, aber auch kontinuierlich das Schaltverhalten anhand wenigstens eines Parameters überwachen, so dass auch die statischen Bereiche überwacht und geregelt werden.

Das Bezugszeichen 2 zeigt schematisch ein in dieser Weise gemessenes Istverhalten des Schaltverhaltens im Bereich einer ansteigenden Flanke, d.h. eines Einschaltvorgangs des Leistungsschalters 1. Im vorliegenden Beispiel wird die an dem Schalter 1 anliegende Spannung U gemessen und geregelt. Wie aus Fig. 1 ersichtlich ist das Istverhalten, das durch die erfindungsgemäße Regelschaltung optimiert ist, derart geregelt, daß die Flanke einen vorbestimmten Verlauf und insbesondere eine vorbestimmte endliche Flankensteilheit aufweist.

Es ist anzumerken, daß durch die erfindungsgemäße Regelschaltung auch andere Flankenverläufe und insbesondere nichtlinear verlaufende Flankenverläufe bei entsprechender Vorgabe (siehe weiter unten im Zusammenhang der Erläuterung des Bezugszeichens 6) erzielt werden können.

Der gemessene Parameter wird einem Eingang 3 der Regeleinrichtung (ASIC) 7 zugeführt. Die Regeleinrichtung 7 weist einen Komparator 8 auf, der das gemessene, an dem Eingang 3 zugeführte Istsignal mit einem extern oder im vorliegenden Beispiel intern vorgegebenen Sollverhalten 6 vergleicht und abhängig von diesem Vergleich zur Implementierung eines Regel-Algorithmus ein Korrektursignal als Ansteuersignal 9 an den Steuereingang des Leistungsschalters 1 abgibt.

Das Sollverhalten 6 kann in unterschiedlicher Weise, beispielsweise unter Zuhilfenahme eines Rechteck-Oszillators mit begrenzter Flankensteilheit, implementiert werden.

Die in Fig. 1 dargestellte Regelschaltung weist eine analoge Schaltung zur Implementierung des Sollverhaltens 6 auf. Dabei kann im Falle einer derartigen analogen Sollwertvorgabe ein kontinuierliches Sollverhalten auferlegt werden.

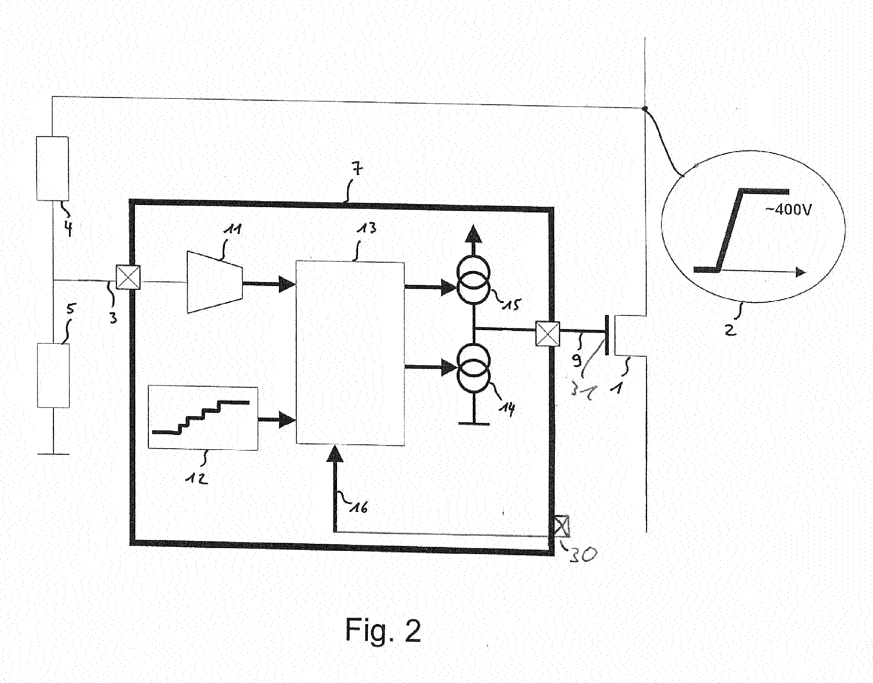

In Fig. 2 ist eine schematische Übersicht über eine digitale Ausführungsform der erfindungsgemäßen Regelschaltung gezeigt.

Wie in der analogen Ausführungsform der Fig. 1 wird ein Leistungsschalter 1 von einem Ansteuersignal 9 gespeist. Das Istverhalten eines Parameters des Leistungsschalters 9 - wie beispielsweise des Stroms und/oder der Spannung durch den bzw. an dem Leistungsschalter 9 - wird wiederum von einer Regeleinrichtung 7 mit Hilfe eines Spannungsteilers 4, 5 erfasst.

Die Funktion der Regeleinrichtung 7 besteht in einem Vergleich des gemessenen Istverhaltens mit einem vorgegebenen Sollverhalten 12 und in einer dementsprechenden Ansteuerung 9 des Leistungsschalters 9.

Der Vergleich der Ist- und Sollverhalten und die zeitliche Reaktion darauf wird von einer Logikschaltung 13 durchgeführt, die u.a. die Funktion eines digitalen Komparators enthält. Ein Analog-Digital-Wandler 11 zur Digitalisierung des erfassten Eingangs-Parameters 3 liefert der Logikschaltung 13 das entsprechende digitale Istverhalten. Die das Sollverhalten wiedergebenden diskreten Digitalwerte werden aus einem Speicher 12 einem weiteren Eingang der Logikschaltung 13 zugeführt.

Ein weiterer Eingang der Logikschaltung 13 dient als Steuereingang 16. Über den Steuereingang 16 lässt sich bspw. das dynamische Regelverhalten mittels Einstellung der zeitlichen Reaktion der Logikschaltung auf Regelabweichungen einstellen.

Eine Bereitstellung des Sollverhaltens mittels digitaler Werte in einem Speicher gemäss dem Ausführungsbeispiel von Figur 2 hat den Vorteil, daß im wesentlichen beliebige, auch nichtlineare Verläufe insbesondere im Bereich der Flanken für das Schaltverhalten vorgegeben werden können.

Minimal sind dabei für eine Flanke zwei diskrete Stützwerte in dem Speicher 12 abgelegt, wodurch bereits eine geradlinig verlaufende Flanke vorgegeben werden kann. Für komplexere Flankenverläufe oder aber auch zur Präzisierung derartiger geradliniger Flanken kann selbstverständlich die Anzahl der Stützwerte, die das Sollverhalten wiedergeben, beliebig erhöht werden.

Nachdem die Logikschaltung 13 der Regeleinrichtung 7 die Ist- und Sollverhalten in der Art eines Fehlerverstärkers ("Error Amplifier") verglichen hat, steuert er programmierbare Stromquellen 14, 15 derart an, dass der Leistungsschalter 1 mit dem gewünschten Ansteuersignal 9 betrieben wird, also das Istverhalten im wesentlichen dem Sollverhalten folgt.

Die gerade beschriebenen analogen und digitalen Ausführungsbeispiele betreffen also eine Ausführungsform, bei der eine geschlossene Regelschleife während des Betriebs des Leistungsschalters 1 die Ansteuerung korrekturmäßig nachregelt, um das Sollverhalten zu erreichen.

Indessen betrifft die vorliegende Erfindung auch die einmalige Kalibrierung einer Ansteuerschaltung, bei der ein bestehendes Schaltverhalten 2 des Leistungsschalters 1 einmalig mittels eines speziellen Messgeräts 18 erfasst wird und dann eine einmalige, bspw. werksseitige Kalibrierung der Ansteuerschaltung 7 durchgeführt wird.

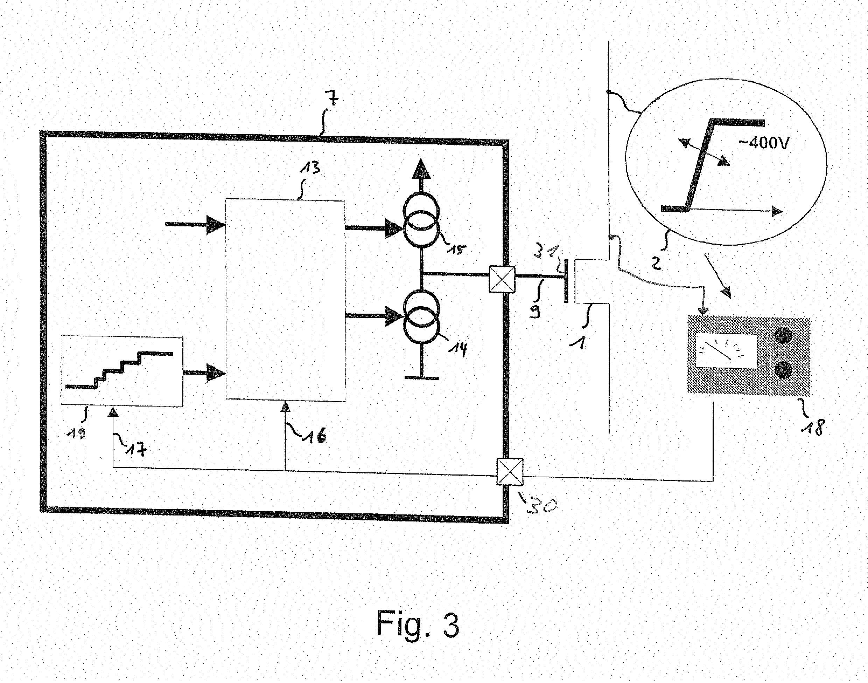

Dies ist schematisch in Fig. 3 dargestellt. Bei dieser Ausführungsform ist ein externer oder hier interner, programmierbarer Kalibrierspeicher 19 vorgesehen (bei den zuvor genannten Ausführungsbeispielen ist der Speicher 6 bzw. 12 nicht notwendigermassen programmierbar).

Beispielsweise bei der Fertigung wird also die Ansteuerschaltung 7 einmalig kalibriert, so daß dann im eigentlichen Betrieb des Leistungsschalters 1 eine Messung und eine geschlossene Regelschleife zur Verwertung des Meßergebnisses des Leistungsschalters-Parameters nicht erforderlich sind.

Die Messung und Kalibrierung kann indessen jederzeit, bspw. in fest vorgegebenen Abständen oder bei Auferlegung einer neuen Funktionalität erneut durchgeführt werden.

Die Kalibrierung kann dabei wie dargestellt durch interne Abspeicherung 19 von Kalibrierdaten erfolgen, die den zeitlichen Verlauf der Ansteuerung beeinflussen. Vorstellbar ist aber auch eine externe Kalibrierung über einen Trimmeingang etc. (nicht dargestellt).

Zur Kalibrierung wird also über ein Messgerät 18 das Schaltverhalten erfasst. Über einen Programmiereingang 30 der integrierten Schaltung 7 können dann die Werte des Kalibrierspeichers 19 (Programmierzugriff 17) und/oder das dynamische Verhalten ("Control Pattern")der Logikschaltung 13 eingestellt werden.

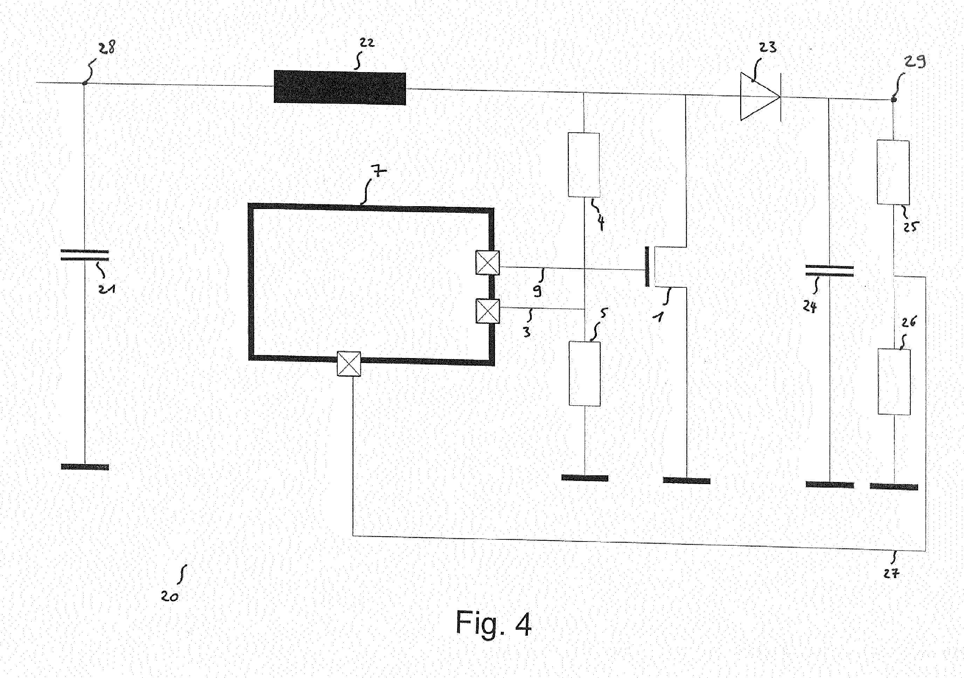

Fig. 4 zeigt schließlich, wie die erfindungsgemäße Technik bei einer PFC (Power Factor Correction)-Schaltung angewendet werden kann. In dem Ausführungsbeispiel von Fig. 4 wird beispielsweise die Spannung über dem Leistungsschalter 1 überwacht, um durch gezielte Ansteuerung des Schalters eine Verringerung durch hochfrequente Störungen zu erzielen.

Wie aus dem Stand der Technik grundsätzlich bekannt, wird die Eingangs-Spannung 28 einer PFC-Schaltung 20 von einem Glättungskondensator 21 gesiebt und einer Induktivität 22, i.e. einer Spule, zugeführt. Die Induktivität 22 wird mittels des Leistungsschalters 1 wahlweise geladen bzw. entladen. Die PFC-Schaltung 20 weißt außerdem eine in Serie zu der Induktivität 22 geschaltete Diode 23 auf.

Wenn der Leistungsschalter 1 eingeschaltet ist, ist die Induktivität 22 gegen Masse kurzgeschlossen und die Diode 23 gesperrt. Die Induktivität 22 lädt sich dann auf, so dass Energie in der Induktivität 22 gespeichert wird.

Wenn der Leistungsschalter 1 hingegen ausgeschaltet ist, ist die Diode 23 leitend. Die Induktivität 22 entlädt sich dann über die Diode 23 in den Ausgangs-Kondensator 24. Die Energie wird dadurch an den Ausgangs-Kondensator 24 übertragen.

Der Spannungsteiler 4, 5 dient dazu, das Istverhalten des Stroms und/oder der Spannung durch den bzw. an dem Leistungsschalter 1 zu ermitteln 3. Mittels eines weiteren Spannungsteilers 25, 26 kann die Ausgangs-Spannung 29 gemessen werden 27.

Die im ASIC 7 vorgesehene Treiberschaltung für die Ansteuerung des Leistungsschalters 1 ist in den Figuren nicht dargestellt.

Durch die geschlossene Regelschleife bzw. die Kalibrierung können Toleranzen des Leistungsschalters l kompensiert werden, so daß stets im wesentlichen das gewünschte Sollverhalten erzielt werden kann. Somit kann beispielsweise dasselbe ASIC für verschiedene Leistungsstufen von Gasentladungslampen verwendet werden, die unterschiedlich dimensionierte Schalter benötigen. Insgesamt ergibt sich also ein geregeltes Schaltverhalten.

Bei der Kalibrierung kann sozusagen eine "Universal-Treiberschaltung" vorgesehen sein, die abhängig von der zuvor ausgeführten Messung des entsprechenden Parameters des Leistungsschalters auf den speziell verwendeten Leistungsschalter hin spezifiziert wird.

Liste der in den Figuren benutzten Bezugszeichen:

| | |
|---|---|
| 1 | Leistungsschalter, bspw. FET-Transistor |
| 2 | gemessenes Istverhalten des Stroms und/oder der Spannung durch den bzw. an dem Leistungsschalter |
| 3 | Eingang der Regeleinrichtung |
| 4 | Widerstand eines Spannungsteilers |
| 5 | Widerstand eines Spannungsteilers |
| 6 | analoges vorgegebenes Sollverhalten |
| 7 | Regeleinrichtung: integrierte Schaltung (ASIC), bzw. diskrete Schaltung |
| 8 | Komparator |
| 9 | Ansteuersignal des Leistungsschalters |
| 10 | Darstellung des Ansteuersignals |
| 11 | Analog-Digital-Wandler |
| 12 | digitales vorgegebenes Sollverhalten, bzw. digitaler Speicher |
| 13 | digitale Logikschaltung |
| 14 | Stromquelle |
| 15 | Stromquelle |
| 16 | Steuereingang |
| 17 | externe Abspeicherung von Kalibrierdaten |
| 18 | Messgerät |
| 19 | Kalibrierspeicher |
| 20 | PFC-Schaltung |
| 21 | Glättungskondensator |
| 22 | Induktivität |
| 23 | Diode |
| 24 | Ausgangs-Kondensator |
| 25 | Widerstand eines Spannungsteilers |
| 26 | Widerstand eines Spannungsteilers |
| 27 | gemessene Ausgangs-Spannung |
| 28 | Eingangs-Spannung |
| 29 | Ausgangs-Spannung |

## Patentansprüche

1. Ansteuerschaltung (7) für einen Leistungsschalter (1) zur elektrischen Versorgung von Geräten, mit einem Kalibrierspeicher (19), in dem Kalibrierdaten abgelegt sind, die eingerichtet sind, einen zeitlichen Verlauf der Ansteuerung des Leistungsschalters (1) zu beeinflussen, indem sie einen zeitlichen Sollverlauf der Spannung am Leistungsschalter (1) während einer Einschaltflanke wiedergeben, **dadurch gekennzeichnet, dass** die Kalibrierdaten so eingerichtet sind, dass der zeitliche Sollverlauf der Spannung am Leistungsschalter (1) während der Einschaltflanke mittels wenigstens zweier diskreter Stützwerte wiedergegeben wird und die wenigstens zwei diskreten Stützwerte damit einen Flankenverlauf der Einschaltflanke vorgeben.

2. Ansteuerschaltung (7) nach Anspruch 1, **dadurch gekennzeichnet, dass** der Kalibrierspeicher ein interner oder externer Speicher der Ansteuerschaltung ist.

3. Ansteuerschaltung (7) nach Anspruch 1 oder 2, **dadurch gekennzeichnet, dass** der Kalibrierspeicher programmierbar ist.

4. Ansteuerschaltung (7) nach einem der vorhergehenden Ansprüche, **dadurch gekennzeichnet, dass** im eigentlichen Betrieb keine Einheit zur Messung und keine geschlossene Regelschleife zur Verwertung eines Messergebnisses eines Leistungsschalters-Parameters vorgesehen sind.

5. Ansteuerschaltung nach einem der vorhergehenden Ansprüche, **dadurch gekennzeichnet, dass** der Kalibrierspeicher (19) derart ausgeführt ist, dass eine Kalibrierung mehrfach durchführbar ist.

6. Ansteuerschaltung nach einem der vorhergehenden Ansprüche, **dadurch gekennzeichnet, dass** die Ansteuerschaltung eine integrierte Schaltung (7) ist.

7. Ansteuerschaltung nach Anspruch 6, **dadurch gekennzeichnet, dass** die Ansteuerschaltung einen Programmiereingang (30) für den Kalibrierspeicher (19) aufweist.

8. Kombination einer Ansteuerschaltung nach einem der vorhergehenden Ansprüche mit einem Leistungsschalter (1), wobei der Leistungsschalter (1) für ein Betriebsgerät für Leuchtmittel vorgesehen ist.

9. Kombination nach Anspruch 8, bei der der Leistungsschalter ein FET (1) ist.

10. Betriebsgerät für Leuchtmittel, aufweisend eine Kombination nach Anspruch 8 oder 9.

11. Verwendung einer Ansteuerschaltung nach einem der vorhergehenden Ansprüche 1 bis 7 für die Ansteuerung eines Leistungsschalters (1) für ein Betriebsgerät.

12. Verfahren zum Betrieb einer Ansteuerschaltung (7) für einen Leistungsschalter (1) zur elektrischen Versorgung von Geräten, wobei der zeitliche Verlauf der Ansteuerung des Leistungsschalters (1) abhängig von Kalibierdaten erfolgt, die in einem Kalibrierspeicher (19) abgelegt sind und den zeitlichen Sollverlauf der Spannung am Leistungsschalter (1) während einer Einschaltflanke mittels wenigstens zweier diskreter Stützwerte wiedergeben, wobei die wenigstens zwei diskreten Stützwerte einen Flankenverlauf der Einschaltflanke vorgeben.

13. Verfahren nach Anspruch 12, bei dem die Kalibrierdaten programmiert werden.

## Claims

1. A control circuit (7) for a power switch (1) for the electrical supply of devices, having a calibration memory (19) in which calibration data are stored which are configured to influence a time characteristic of the control of the power switch (1) by reproducing a desired time characteristic of the voltage at the power switch (1) during a rising edge, **characterized in that** the calibration data are configured such that the desired time characteristic of the voltage at the power switch (1) during the rising edge is reproduced by means of at least two discrete supporting values and the at least two discrete supporting values thus specify an edge characteristic of the rising edge.

2. The control circuit (7) according to Claim 1, **characterized in that** the calibration memory is an internal or external memory of the control circuit.

3. The control circuit (7) according to Claim 1 or 2, **characterized in that** the calibration memory is programmable.

4. The control circuit (7) according to any of the preceding claims, **characterized in that** in actual operation, no unit is provided for measurement and no closed control loop is provided for utilizing a measurement result of a power switch parameter.

5. The control circuit according to any of the preceding claims, **characterized in that** the calibration memory (19) is designed in such a way that a calibration can be performed several times.

6. The control circuit according to any of the preceding claims, **characterized in that** the control circuit is an integrated circuit (7).

7. The control circuit according to Claim 6, **characterized in that** the control circuit has a programming input (30) for the calibration memory (19).

8. A combination of a control circuit according to any of the preceding claims with a power switch (1), wherein the power switch (1) is provided for a control device for illuminants.

9. The combination according to Claim 8, in which the power switch is an FET (1).

10. A control device for illuminants, comprising a combination according to Claim 8 or 9.

11. A use of a control circuit according to any of the preceding Claims 1 to 7 for controlling a power switch (1) for a control device.

12. A method for operating a control circuit (7) for a power switch (1) for the electrical supply of devices, wherein the time characteristic of the control of the power switch (1) depends on calibration data which are stored in a calibration memory (19) and reproduce the desired time characteristic of the voltage at the power switch (1) during a rising edge by means of at least two discrete supporting values, wherein the at least two discrete supporting values specify an edge characteristic of the rising edge.

13. The method according to Claim 12, in which the calibration data are programmed.

## Revendications

1. Circuit de commande (7) pour un commutateur de puissance (1) pour l'alimentation électrique d'appareils, comprenant une mémoire de calibration (19), dans laquelle sont stockées des données de calibration, lesquelles sont configurées pour influencer une courbe temporelle de la commande du commutateur de puissance (1), en reproduisant une courbe temporelle de consigne de la tension au niveau du commutateur de puissance (1) pendant un front d'enclenchement, **caractérisé en ce que** les données de calibration sont configurées de telle façon que la courbe temporelle de consigne de la tension au niveau du commutateur de puissance (1) est reproduite pendant le front d'enclenchement au moyen d'au moins deux valeurs de base discrètes et que les au moins deux valeurs de base discrètes prédéfinissent ainsi une courbe de front du front d'enclenchement.

2. Circuit de commande (7) selon la revendication 1, **caractérisé en ce que** la mémoire de calibration est une mémoire interne ou externe du circuit de commande.

3. Circuit de commande (7) selon la revendication 1 ou 2, **caractérisé en ce que** la mémoire de calibration peut être programmée.

4. Circuit de commande (7) selon l'une quelconque des revendications précédentes, **caractérisé en ce que,** durant le fonctionnement même, aucune unité n'est prévue pour la mesure ni aucune boucle de réglage pour l'évaluation d'un résultat de mesure d'un paramètre du commutateur de puissance.

5. Circuit de commande selon l'une quelconque des revendications précédentes, **caractérisé en ce que** la mémoire de calibration (19) est conçue de telle façon qu'une calibration peut être réalisée plusieurs fois.

6. Circuit de commande selon l'une quelconque des revendications précédentes, **caractérisé en ce que** le circuit de commande est un circuit intégré (7).

7. Circuit de commande selon la revendication 6, **caractérisé en ce que** le circuit de commande présente une entrée de programmation (30) pour la mémoire de calibration (19).

8. Combinaison d'un circuit de commande selon l'une quelconque des revendications précédentes avec un commutateur de puissance (1), le commutateur de puissance (1) étant prévu pour un appareil de commande d'un moyen d'éclairage.

9. Combinaison selon la revendication 8, dans laquelle le commutateur de puissance est un FET (1).

10. Appareil de commande pour moyen d'éclairage, présentant une combinaison selon la revendication 8 ou 9.

11. Utilisation d'un circuit de commande selon l'une quelconque des revendications 1 à 7 précédentes pour la commande d'un commutateur de puissance (1) pour un appareil de commande.

12. Procédé pour faire fonctionner un circuit de commande (7) pour un commutateur de puissance (1) pour l'alimentation électrique d'appareils, la courbe temporelle de la commande du commutateur de puissance (1) étant réalisée en fonction de données de calibration, qui sont stockées dans une mémoire de calibration (19) et reproduisent la courbe temporelle de consigne de la tension au niveau du commutateur de puissance (1) pendant un front d'enclenchement au moyen d'au moins deux valeurs de base discrète, les au moins deux valeurs de base discrètes prédéfinissant une courbe de front du front d'enclenchement.

13. Procédé selon la revendication 12, dans lequel les données de calibration sont programmées.
